# EUROPÄISCHE PATENTSCHRIFT

(11) **EP 2 856 504 B1**
(45) Veröffentlichungstag und Bekanntmachung des Hinweises auf die Patenterteilung: **06.06.2018**
(21) Anmeldenummer: 13716325.9
(22) Anmeldetag: 17.04.2013
(51) Int. Cl.: H01L 25/16, H01L 33/48, H01L 33/62, H01L 33/64

(54) **LEUCHTDIODENVORRICHTUNG**
LIGHT DIODE DEVICE
DISPOSITIF À DIODE ÉLECTROLUMINESCENTE

(30) Priorität: 24.05.2012 DE 102012104494
(43) Veröffentlichungstag der Anmeldung: 08.04.2015
(73) Patentinhaber: Epcos AG, 81671 München (DE)
(72) Erfinder: FEICHTINGER, Thomas, A-8010 Graz (AT); DERNOVSEK, Oliver, A-8501 Lieboch (AT); AICHHOLZER, Klaus-Dieter, A-8530 Deutschlandsberg (AT); BRUNNER, Sebastian, A-8042 Graz (AT)
(74) Vertreter: Epping - Hermann - Fischer
(86) Internationale Anmeldenummer: PCT/EP2013/058009
(87) Internationale Veröffentlichungsnummer: WO 2013/174583

(56) Entgegenhaltungen:
- EP-A2- 2 224 485
- WO-A1-2007/058438
- WO-A1-2009/141266
- JP-A- 2007 150 229
- US-A1- 2007 018 191
- US-A1- 2007 200 133
- US-A1- 2008 083 929
- US-A1- 2008 238 604
- US-A1- 2010 078 668
- US-A1- 2010 219 733

## Beschreibung

Es wird eine Leuchtdiodenvorrichtung angegeben, die einen Träger mit zumindest einer Kavität sowie einen Leuchtdiodenchip aufweist.

Es sind Licht emittierende Dioden ("LEDs") bekannt, bei denen ein LED-Chip und ein Schutzbauelement auf einem ebenen Träger angeordnet sind. Durch das Schutzbauelement kann vom LED-Chip emittiertes Licht abgeschattet werden. WO 2007/058438 A1 (AMOSENSE CO LTD [KR]; LEE YOUNG-IL [KR]; PARK, JONG-WEON [KR]; CHO, YUN-MIN; Veröffentlichungsdatum: 24. Mai 2007), US 2010/078668 A1 (KIM GEUN HO [KR]; Veröffentlichungsdatum: 1. April 2010) und US 2010/219733 A1 (WAN SHAN MEI [HK] ET AL; Veröffentlichungsdatum: 2. September 2010) offenbaren Leuchtdiodenvorrichtungen mit Schutzelementen.

Die Erfindung offenbart eine Leuchtdiodenvorrichtung gemäß dem unabhängigen Anspruch 1.

Vorteilhafte Ausführungsformen der Erfindung sind in den abhängigen Ansprüchen offenbart. Eine Leuchtdiodenvorrichtung gemäß zumindest einer Ausführungsform weist einen Träger auf. Der Träger kann einen Grundkörper aufweisen. Beispielsweise kann der Träger einen keramischen Grundkörper aufweisen. Alternativ ist es auch möglich, dass der Träger einen Grundkörper aufweist, der ein organisches Material aufweist. Beispielsweise kann der Grundkörper eine Leiterplatte umfassen, die ein organisches Material aufweist.

Gemäß einer weiteren Ausführungsform weist der Grundkörper ein halbleitendes Material auf. Gemäß einer bevorzugten Ausführungsform weist der Grundkörper ein keramisches Varistormaterial auf. Beispielsweise weist der Grundkörper SrTiO3, ZnO-Pr oder ZnO-Bi auf. Weiterhin ist es möglich, dass der Grundkörper ein Komposit aus ZnO-Pr und Glas oder ein Komposit aus ZnO-Pr und einem organischen Material aufweist oder aus einem Komposit aus ZnO-Pr und Glas oder aus ZnO-Pr und einem organischen Material besteht. Mit dem Begriff "Komposit" kann dabei hier und im Folgenden insbesondere ein Material bezeichnet sein, das durch einen Verbund oder eine Mischung aus zumindest zwei verschiedenen Stoffen gebildet wird.

Gemäß einer weiteren Ausführungsform weist der Grundkörper Aluminiumoxid, Aluminiumnitrid oder eine Keramik des Typs LTCC ("low temperature cofired ceramics") auf oder besteht aus einem dieser Materialien.

Gemäß einer weiteren Ausführungsform weist die Leuchtdiodenvorrichtung einen Leuchtdiodenchip auf. Vorzugsweise weist der Leuchtdiodenchip mindestens eines der folgenden Materialien auf: Galliumphosphid (GaP), Galliumnitrid (GaN), Galliumarsenphosphid (GaAsP), Aluminiumgalliumindiumphosphid (AlGaInP), Aluminiumgalliumphosphid (AlGaP), Aluminiumgalliumarsenid (AlGaAs), Indiumgalliumnitrid (InGaN), Aluminiumnitrid (AlN), Aluminiumgalliumnitrid (AlGaN), Aluminiumgalliumindiumnitrid (AlGaInN), Zinkselenid (ZnSe).

Gemäß einer weiteren Ausführungsform weist der Leuchtdiodenchip mindestens zwei Kontaktflächen auf. Vorzugsweise sind die Kontaktflächen lötbar. Beispielsweise weisen die Kontaktflächen eine Legierung oder eine Schichtfolge mit einer der folgenden Materialkombinationen auf oder bestehen daraus: Cu/Ni/Au, Cr/Ni/Au, Cr/Cu/Ni/Au, Cu/Ni/Sn, Cr/Ni/Sn, Cr/Cu/Ni/Sn.

Gemäß der erfindungsgemäßen Ausführungsform weist die Leuchtdiodenvorrichtung ein ESD-Schutzelement auf. Dabei steht "ESD" hier und im Folgenden für "electrostatic discharge". Das ESD-Schutzelement wird durch einen Teilbereich des Trägers gebildet.

Besonders bevorzugt kann das ESD-Schutzelement eine in den Träger und/oder in den Grundkörper integrierte Schutzstruktur sein. Mit anderen Worten ist das ESD-Schutzelement nicht als diskretes Bauelement, beispielsweise in Form einer diskreten ESD-Schutzdiode, auf dem Träger montiert. Dabei kann es sein, dass das ESD-Schutzelement ein Material, zum Beispiel ein keramisches Varistormaterial, aufweist, das auch der Träger und/oder der Grundkörper aufweist. Alternativ ist es möglich, dass das ESD-Schutzelement ein Material aufweist, das vom Material oder den Materialien des Trägers und/oder des Grundkörpers verschieden ist. Beispielsweise kann das ESD-Schutzelement ein halbleitendes Material, zum Beispiel ein keramisches Varistormaterial, aufweisen, das in den Träger, der beispielsweise Aluminiumoxid, Aluminiumnitrid oder ein organisches Material aufweist, eingebettet ist.

Gemäß einer weiteren Ausführungsform ist das ESD-Schutzelement als Varistor ausgeführt. Beispielsweise weist das ESD-Schutzelement Varistormaterial oder ein Komposit aus einem Varistormaterial und einem Metall auf.

Gemäß einer weiteren Ausführungsform weist das ESD-Schutzelement eine Varistorkeramik und eine Mehrzahl von sich überlappenden Innenelektroden auf. Die Innenelektroden werden vorzugsweise abwechselnd kontaktiert, beispielsweise mittels Vias, die zum Beispiel von einer oder mehreren Oberflächen des Trägers in den Grundkörper geführt sind. Die Innenelektroden weisen vorzugsweise Silber oder Silber-Palladium auf. Alternativ ist es auch denkbar, dass das ESD-Schutzelement durch eine in den Träger integrierte Halbleiterdiode gebildet ist.

Das ESD-Schutzelement dient vorzugsweise zum Schutz des Leuchtdiodenchips vor Überspannungen, insbesondere vor elektrostatischen Entladungen. Im Allgemeinen sind Leuchtdiodenchips sehr sensitiv gegenüber elektrostatischen Entladungen, insbesondere bei solchen mit einem Spannungswert von größer als 100 Volt, und müssen daher durch Schutzbauelemente geschützt werden.

Dadurch, dass das ESD-Schutzelement durch einen Teilbereich des Trägers der Leuchtdiodenvorrichtung gebildet wird, kann vorteilhafterweise eine besonders kompakte Bauweise einer hier beschriebenen Leuchtdiodenvorrichtung erzielt werden.

Gemäß einer weiteren Ausführungsform weist die Leuchtdiodenvorrichtung zumindest ein elektrisches Bauelement auf. Das elektrische Bauelement ist beispielsweise ein diskretes elektrisches Bauelement, das keine optoelektronischen Eigenschaften aufweist. Das kann insbesondere bedeuten, dass es sich bei dem elektrischen Bauelement weder um ein Licht emittierendes noch um ein Licht empfangendes elektrisches Bauelement handelt. Das elektrische Bauelement kann insbesondere mit dem Leuchtdiodenchip verschaltet sein. Vorzugsweise ist das elektrische Bauelement auf dem Träger angeordnet.

Gemäß einer weiteren Ausführungsform weist das elektrische Bauelement mindestens zwei Kontaktflächen auf. Vorzugsweise sind die Kontaktflächen lötbar. Beispielsweise weisen die Kontaktflächen eine Legierung oder eine Schichtfolge mit einer der folgenden Materialkombinationen auf oder bestehen daraus: Cu/Ni/Au, Cr/Ni/Au, Cr/Cu/Ni/Au, Cu/Ni/Sn, Cr/Ni/Sn, Cr/Cu/Ni/Sn.

Gemäß einer weiteren Ausführungsform ist das elektrische Bauelement ein ultradünnes Schutzbauelement. Das kann insbesondere bedeuten, dass das elektrische Bauelement eine Bauhöhe von kleiner oder gleich 150 µm aufweisen kann.

Gemäß einer weiteren Ausführungsform weist das elektrische Bauelement eine oberflächenmontierbare Terminierung auf. Beispielsweise kann das elektrische Bauelement ein oberflächenmontiertes Bauelement (SMD, "surface-mounted device") sein. Das elektrische Bauelement kann des Weiteren eine BGA-Gehäuseform (BGA, "Ball Grid Array") oder eine LGA-Gehäuseform (LGA, "Land Grid Array") aufweisen.

Gemäß der erfindungsgemäßen Ausführungsform sind die elektrischen Bauelemente Thermistoren. Das Thermistorbauelement kann beispielsweise als sogenanntes NTC-Thermistorbauelement ausgeführt sein, wobei "NTC" für "negative temperature coefficient" steht. Ein NTC-Thermistorbauelement zeichnet sich dadurch aus, dass Strom bei hohen Temperaturen besser geleitet wird als bei niedrigen Temperaturen. Daher wird kann das NTC-Thermistorbauelement auch als Heißleiter bezeichnet werden.

Vorzugsweise funktioniert das NTC-Thermistorbauelement als thermischer Sensor. Der thermische Sensor ist vorzugsweise mit dem Leuchtdiodenchip verschaltet. Beispielsweise kann der thermische Sensor zur Regulierung eines Steuerstroms des Leuchtdiodenchips beitragen, so dass dieser schonend betrieben werden kann. Dadurch kann vorteilhafterweise die Lebensdauer des Leuchtdiodenchips erhöht werden. Außerdem ist erfindungsgemäß ein Thermistorbauelement als sogenanntes PTC-Thermistorbauelement ausgeführt, wobei "PTC" für "positive temperature coefficient" steht. Das PTC-Thermistorbauelement ist vorzugsweise mit dem Leuchtdiodenchip verschaltet. Bei einem PTC-Thermistorbauelement wird Strom bei niedrigen Temperaturen besser geleitet als bei hohen Temperaturen, weshalb das PTC-Thermistorbauelement auch als Kaltleiter bezeichnet wird. Vorzugsweise funktioniert das PTC-Thermistorbauelement als Überstromschutzelement und schützt den Leuchtdiodenchip vor zu hohen Betriebsströmen, wodurch die Lebensdauer des Leuchtdiodenchips gesteigert werden kann. Erfindungsgemäß ist das eine elektrische Bauelement als NTC-Thermistorbauelement und das weitere elektrische Bauelement als PTC-Thermistorbauelement ausgeführt. Gemäß der erfindungsgemäßen Ausführungsform weist der Träger zumindest eine Kavität auf. Die Kavität ist beispielsweise durch eine Vertiefung an einer Oberfläche des Trägers und insbesondere des Grundkörpers gebildet. Vorzugsweise weist die Kavität eine Montagefläche auf, so dass beispielsweise der Leuchtdiodenchip oder das elektrische Bauelement in der Kavität montiert werden können.

Gemäß einer weiteren Ausführungsform ist der Leuchtdiodenchip zumindest teilweise versenkt in der Kavität angeordnet. Beispielsweise kann der Leuchtdiodenchip so in der Kavität angeordnet sein, dass Bereiche des Leuchtdiodenchips über die Kavität hinausragen können. In diesem Fall kann es insbesondere vorteilhaft sein, wenn ein aktiver Bereich des Leuchtdiodenchips, in dem im Betrieb Licht erzeugt wird, unterhalb einer Oberkante der Kavität angeordnet ist. Dadurch kann beispielsweise verhindert werden, dass vom Leuchtdiodenchip erzeugtes Licht direkt auf ein auf dem Träger angeordnetes Bauelement trifft und dadurch abgeschattet wird.

Gemäß der erfindungsgemäßen Ausführungsform weist die Leuchtdiodenvorrichtung einen Träger mit zumindest einer Kavität, einen Leuchtdiodenchip, der zumindest teilweise versenkt in der zumindest einen Kavität angeordnet ist, sowie ein ESD-Schutzelement, das durch einen Teilbereich des Trägers gebildet wird, auf.

Gemäß einer weiteren bevorzugten Ausführungsform ist der Leuchtdiodenchip in der Kavität vollständig versenkt angeordnet. Dass ein Bauteil in einer Kavität "vollständig versenkt" angeordnet ist, kann dabei insbesondere bedeuten, dass die Kavität eine Tiefe aufweist, die größer oder gleich einer Höhe des in der Kavität angeordneten Bauteils ist, so dass kein Bereich des Bauteils über die Kavität hinausragt. Gemäß einer weiteren Ausführungsform weist die Kavität, in der der Leuchtdiodenchip angeordnet ist, eine Bodenfläche sowie Seitenflächen auf. Die Seitenflächen verlaufen vorzugsweise schräg zur Bodenfläche. Beispielsweise schließen die Seitenflächen mit der Bodenfläche jeweils einen Winkel zwischen 120° und 150° ein. Gemäß einer bevorzugten Ausführungsform schließen die Seitenflächen mit der Bodenfläche jeweils einen Winkel zwischen 130° und 140° ein. Besonders bevorzugt schließen die Seitenflächen mit der Bodenfläche jeweils einen Winkel von 135° ein.

Gemäß einer weiteren Ausführungsform weist die Kavität, in der der Leuchtdiodenchip angeordnet ist, eine reflektierende Schicht auf. Beispielsweise können die Seitenflächen und/oder die Bodenfläche der Kavität mit der reflektierenden Schicht beschichtet sein.

Mittels der schräg zur Bodenfläche verlaufenden Seitenflächen der Kavität sowie der auf den Seitenflächen und/oder der Bodenfläche angeordneten reflektierenden Schicht kann eine besonders gute Ausbeute des von dem Leuchtdiodenchip emittierten Lichts erzielt werden, da der Teil des Lichts, der vom Leuchtdiodenchip im Betrieb in Richtung der Seitenwände und/oder der Bodenfläche der Kavität abgestrahlt wird, aus der Kavität hinaus reflektiert werden kann.

Gemäß einer weiteren Ausführungsform ist der Leuchtdiodenchip auf dem Träger angeordnet, ohne in einer Kavität versenkt zu sein. Beispielsweise kann der Leuchtdiodenchip auf einer Oberfläche des Trägers und/oder des Grundkörpers aufgebracht sein.

Gemäß der erfindungsgemäßen Ausführungsform sind das elektrische Bauelement und ein weiteres elektrisches Bauelement in einer oder mehreren Kavitäten vollständig versenkt angeordnet. Beispielsweise ist zumindest ein weiteres elektrisches Bauelement vollständig versenkt in der Kavität angeordnet, in der auch das elektrische Bauelement angeordnet ist. Mit anderen Worten kann die Kavität, in der das elektrische Bauelement angeordnet ist, so ausgebildet sein, dass zumindest zwei elektrische Bauelemente darin angeordnet werden können. Dadurch kann ein besonders kompaktes Design einer Leuchtdiodenvorrichtung, die einen Leuchtdiodenchip und zumindest zwei elektrische Bauelemente aufweist, erreicht werden.

Gemäß einer weiteren Ausführungsform sind das elektrische Bauelement und das weitere elektrische Bauelement jeweils vollständig versenkt in einer separaten Kavität angeordnet. Die Kavität, in der das weitere elektrische Bauelement angeordnet ist, kann beispielsweise auf derselben Seite des Trägers angeordnet sein, auf der der Leuchtdiodenchip angeordnet ist. Alternativ die Kavität, in der das weitere elektrische Bauelement angeordnet ist, auf der dem Leuchtdiodenchip gegenüberliegenden Seite des Trägers angeordnet sein.

Gemäß der erfindungsgemäßen Ausführungsform weist die Leuchtdiodenvorrichtung ein NTC-Thermistorbauelement und ein PTC-Thermistorbauelement auf, die in jeweils einer eigenen Kavität oder auch zu Zweien in einer selben Kavität vollständig versenkt angeordnet sind. Dadurch kann bei einer solchen Leuchtdiodenvorrichtung eine Integration von Schutzbauelementen gegen Überströme, beispielsweise in Form eines PTC-Thermistorbauelements, und von Temperatursensoren, beispielsweise in Form eines NTC-Thermistorbauelements, zusammen mit einer besonders geringen Bauhöhe der Leuchtdiodenvorrichtung erreicht werden.

Gemäß einer weiteren Ausführungsform weist der Grundkörper Vias auf. Via steht für "vertical interconnect access" und bezeichnet eine Durchkontaktierung. Vorzugsweise ist zumindest ein Via als thermisches Via ausgeführt, also als thermisch leitende Durchkontaktierung. Weiterhin können mehrere oder alle Vias als thermische Vias ausgebildet sein. Das zumindest eine thermische Via kann vorteilhafterweise die Abführung von Wärme weg vom Leuchtdiodenchip verbessern. Vorzugsweise weist das zumindest eine thermische Via ein Material mit einer guten thermischen Leitfähigkeit auf. Beispielsweise kann das zumindest eine Via von der Bodenfläche der Kavität des Leuchtdiodenchips zu einer von der Kavität des Leuchtdiodenchips abgewandten, insbesondere gegenüber liegenden, Oberfläche des Trägers reichen. Beispielsweise weist das zumindest eine Via Kupfer, Silber oder Silber-Palladium auf oder besteht daraus. Weiterhin kann es auch möglich sein, das zumindest ein Via vorgesehen ist, das als elektrische Zuleitung zwischen dem Leuchtdiodenchip und einer auf einer der Kavität des Leuchtdiodenchips abgewandten Oberfläche des Trägers angeordneten elektrischen Anschlussfläche in Form einer Metallisierung dient.

Gemäß einer weiteren Ausführungsform ist der Leuchtdiodenchip zumindest teilweise von einer Schutzbeschichtung umschlossen. Beispielsweise ist der Leuchtdiodenchip in einer Kavität angeordnet, die von der Schutzbeschichtung bedeckt ist. Die Schutzbeschichtung kann als Linse der Leuchtdiodenvorrichtung dienen. Weiterhin ist es möglich, dass auch eine weitere Kavität und/oder ein in der weiteren Kavität angeordnetes elektrisches Bauelement von der Schutzbeschichtung zumindest teilweise bedeckt sind. Die Schutzbeschichtung weist vorzugsweise Silikon auf oder besteht aus Silikon.

Gemäß einer weiteren Ausführungsform weist der Träger auf einer der Kavität abgewandten Seite eine Metallisierung auf. Die Metallisierung kann sich über die gesamte, der zumindest einen Kavität abgewandten Seite des Trägers erstrecken.
Alternativ kann sich die Metallisierung über einen Teilbereich der der zumindest einen Kavität abgewandten Seite des Trägers erstrecken. Vorzugsweise dient die Metallisierung zum elektrischen Anschluss der Leuchtdiodenvorrichtung, beispielsweise an ein Substrat oder an eine Leiterplatte. Die Metallisierung kann somit auf einer Unterseite des Trägers angeordnet sein, während die Kavität und insbesondere auch der Leuchtdiodenchip auf der gegenüberliegenden Oberseite angeordnet sind.

Gemäß einer weiteren Ausführungsform weist der Grundkörper eine Isolationsschicht auf. Die Isolationsschicht ist vorzugsweise eine elektrisch isolierende Schicht. Beispielsweise kann der Grundkörper ein Varistormaterial aufweisen, das auf zumindest einer Seite mit der Isolationsschicht beschichtet ist. Mittels der Isolationsschicht kann beispielsweise eine elektrische Isolierung zwischen auf dem Träger angeordneten Bauelementen und dem Grundkörper oder Bereichen des Grundkörpers erreicht werden. Vorzugsweise weist die Isolationsschicht eines der folgenden Materialien auf oder besteht aus einem der folgenden Materialien: Titanoxid, Aluminiumoxid, Aluminiumnitrid, Siliziumoxid, Siliziumnitrid.

Die hier beschriebene Leuchtdiodenvorrichtung zeichnet sich insbesondere durch eine geringe Bauhöhe und ein gutes thermisches Management aus. Weiterhin kann bei einer hier beschriebenen Leuchtdiodenvorrichtung erreicht werden, dass die Abstrahlung des Leuchtdiodenchips nicht durch elektrische Bauelemente, wie zum Beispiel diskrete ESD-Schutzbauelemente oder thermische Sensoren, negativ beeinflusst wird.

Weitere Vorteile und vorteilhafte Ausführungsformen der Leuchtdiodenvorrichtung ergeben sich aus den im Folgenden in Verbindung mit den Figuren 1 bis 5 beschriebenen Ausführungsformen.

Es zeigen:
Figur 1 eine schematische Schnittansicht einer Leuchtdiodenvorrichtung gemäß einem nicht erfindungsgemäßen Ausführungsbeispiel,
Figuren 2 bis 3 schematische Schnittansichten von Leuchtdiodenvorrichtungen gemäß weiteren nicht erfindungsgemäßen Ausführungsbeispielen,
Figur 4 eine schematische Schnittansicht einer Leuchtdiodenvorrichtung gemäß einem erfindungsgemäßen Ausführungsbeispiel, und
Figur 5 eine schematische Darstellung eines ESD-Schutzelements gemäß einem Ausführungsbeispiel.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen. Vielmehr können einzelne Elemente wie zum Beispiel Schichten, Bauteile und Bereiche zur besseren Darstellbarkeit und/oder zum besseren Verständnis übertrieben dick oder groß dimensioniert dargestellt sein.

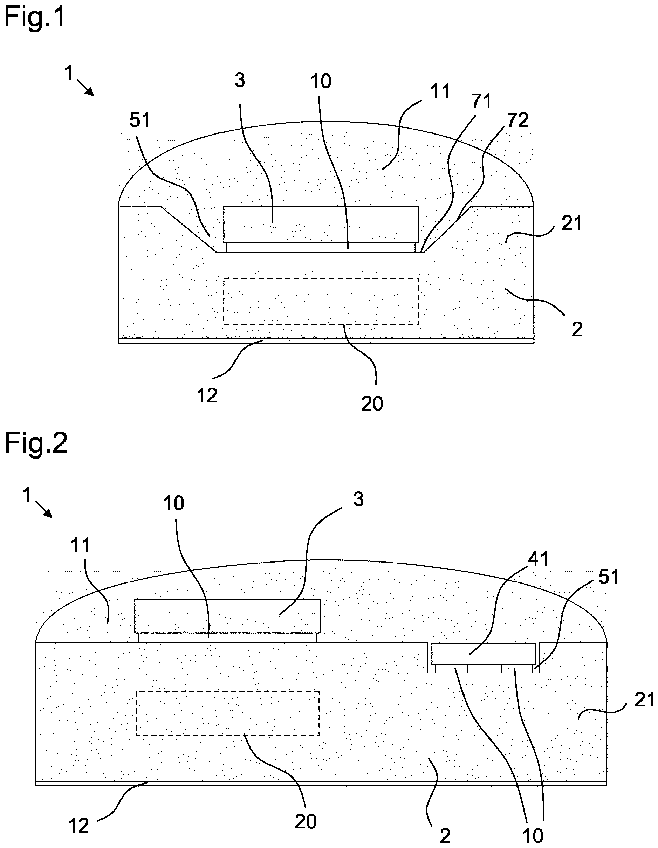

Figur 1 zeigt eine schematische Schnittansicht einer Leuchtdiodenvorrichtung 1 gemäß einem nicht erfindungsgemäßen ersten Ausführungsbeispiel.

Die Leuchtdiodenvorrichtung 1 umfasst einen Träger 2, der einen keramischen Grundkörper 21 aus ZnO-Bi aufweist. Alternativ kann der Grundkörper 21 beispielsweise ZnO-Pr, SrTiO3 oder eine oder mehrere weitere Varistorkeramiken aufweisen. Weiterhin ist es möglich, dass der Grundkörper 21 ein Komposit aus einer Varistorkeramik und Glas oder ein Komposit aus einer Varistorkeramik und einem organischen Material aufweist. Der Träger 2 weist eine Kavität 51 in einer Oberfläche des Trägers 2 und insbesondere des Grundkörpers 21 auf.

Die Leuchtdiodenvorrichtung 1 umfasst weiterhin einen Leuchtdiodenchip 3, der zumindest teilweise versenkt in der Kavität 51 angeordnet ist. Vorteilhafterweise ist der Leuchtdiodenchip 3 wie im Ausführungsbeispiel gemäß Figur 1 gezeigt vollständig versenkt in der Kavität 51 angeordnet.

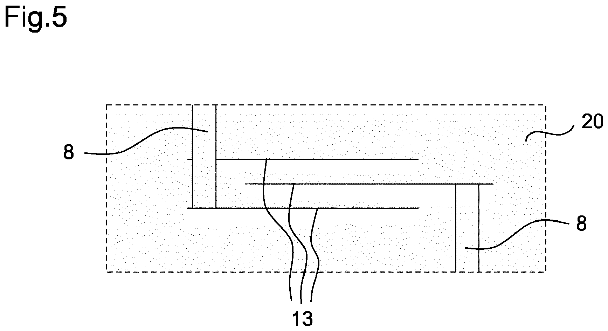

Des Weiteren weist die Leuchtdiodenvorrichtung 1 ein ESD-Schutzelement 20, das durch einen Teilbereich des Trägers 2 gebildet wird. Das ESD-Schutzelement 20 ist dabei, wie weiter unten im Zusammenhang mit Figur 5 beschrieben ist, als Varistor ausgeführt. Alternativ kann das ESD-Schutzelement 20 auch als Halbleiterdiode ausgebildet sein, die in den Träger 2 integriert ist.

Mittels der Integration des ESD-Schutzelements 20 in den Träger 2 der Leuchtdiodenvorrichtung 1 kann vorteilhafterweise erreicht werden, dass die Leuchtdiodenvorrichtung 1 besonders geringe Abmessungen aufweist, da kein zusätzlicher Platz auf dem Träger 2 für das ESD-Schutzelement 20 vorgesehen werden muss. Weiterhin kann vorteilhafterweise vermieden werden, dass ein auf der Oberfläche des Trägers angeordnetes ESD-Schutzbauelement vom Leuchtdiodenchip 3 erzeugtes Licht abschattet.

Die im Träger 2 ausgebildete Kavität 51 weist eine Bodenfläche 71 sowie zwei zu der Bodenfläche 71 unter einem Winkel von größer oder gleich 120° und kleiner oder gleich 150° schräg verlaufende Seitenflächen 72 auf. Die Bodenfläche 71 und die Seitenflächen 72 sind mit einer reflektierenden Schicht (nicht gezeigt) versehen. Mittels der reflektierenden Schicht kann eine Lichtausbeute eines vom Leuchtdiodenchip 3 abgestrahlten Lichts verbessert werden, indem vom Leuchtdiodenchip 3 abgestrahltes, auf die mit der reflektierenden Schicht beschichteten Flächen auftreffendes Licht zu einem großen Teil reflektiert und nicht absorbiert wird.

Der Leuchtdiodenchip 3 weist Kontaktflächen auf, die der Kontaktierung und/oder der Montage des Leuchtdiodenchips 3 dienen und von denen rein beispielhaft eine Kontaktfläche 10 gezeigt ist, mit der der Leuchtdiodenchip 3 auf der Bodenfläche 71 der Kavität 51 befestigt ist. Vorzugsweise ist der Leuchtdiodenchip auf die Bodenfläche 71 aufgelötet. Die Kontaktfläche 10 weist eine Gold-Zinn Legierung auf. Alternativ kann die Kontaktfläche 10 Kupfer, Nickel oder Gold oder eine Legierung oder Schichtenfolge aus zumindest zweien dieser Materialien aufweisen.

Auf der der Kavität 51 abgewandten Seite des Trägers 2 ist eine Metallisierung 12 auf dem Grundkörper 21 aufgebracht. Die Metallisierung 12 dient zum elektrischen Anschluss der Leuchtdiodenvorrichtung 1. Der Träger 2 und insbesondere der Grundkörper 21 weist weiterhin noch Durchkontaktierungen und/oder Leiterbahnen zur Verschaltung der gezeigten Elemente auf, die der Übersichtlichkeit halber nicht gezeigt sind.

Weiterhin sind der Leuchtdiodenchip 3 und das elektrische Bauelement 41 von einer Schutzbeschichtung 11 umschlossen. Die Schutzbeschichtung 11 weist Silikon auf und wirkt als Linse. Weiterhin kann die Schutzbeschichtung 11 als Wellenlängenkonversionsschicht ausgeführt sein. Alternativ zum gezeigten Ausführungsbeispiel kann die Leuchtdiodenvorrichtung auch keine Schutzbeschichtung 11 aufweisen oder nur teilweise, beispielsweise über dem Leuchtdiodenchip 3, mit einer Schutzbeschichtung versehen sein.

Die weiteren Figuren zeigen Ausführungsbeispiele, die Modifikationen und Varianten des in Figur 1 gezeigten nicht erfindungsgemäßen Ausführungsbeispiels sind und die daher vor allem im Hinblick auf die Unterschiede hierzu erläutert werden.

In Figur 2 ist eine schematische Schnittansicht einer Leuchtdiodenvorrichtung 1 gemäß einem weiteren nicht erfindungsgemäßen Ausführungsbeispiel gezeigt. Im Unterschied zu dem in Figur 1 gezeigten Ausführungsbeispiel ist der Leuchtdiodenchip 3 auf einer Oberfläche des Trägers 2 angeordnet, ohne in einer Kavität versenkt zu sein.

Weiterhin weist die Leuchtdiodenvorrichtung 1 ein elektrisches Bauelement 41 auf, das im gezeigten Ausführungsbeispiel als NTC-Thermistorbauelement ausgeführt ist. Alternativ kann das elektrische Bauelement 41 auch als PTC-Thermistorbauelement ausgeführt sein. Das elektrische Bauelement 41 ist in der Kavität 51 vollständig versenkt angeordnet. Durch die Versenkung des elektrischen Bauelements 41 in der Kavität 51 kann somit vorteilhafterweise verhindert werden, dass vom Leuchtdiodenchip 3 abgestrahltes Licht direkt auf das elektrische Bauelement 41 trifft, was zu einer Abschattung durch das elektrische Bauelement 41 führen würde.

Das elektrische Bauelement 41 weist zwei Kontaktflächen 10 auf, mit denen es auf einer Bodenfläche der Kavität 51 befestigt ist. Alternativ kann das elektrische Bauelement 41 auch mehr Kontaktflächen 10 aufweisen. Die Kontaktflächen 10 dienen der elektrischen Kontaktierung und der Montage des elektrischen Bauelements 41. Die Kontaktflächen 10 weisen eine Legierung oder Schichtenfolge aus Cu/Ni/Au auf.

Alternativ können die Kontaktflächen 10 eine Legierung oder Schichtenfolge aus Cr/Ni/Au oder aus Cr/Cu/Ni/Au aufweisen.

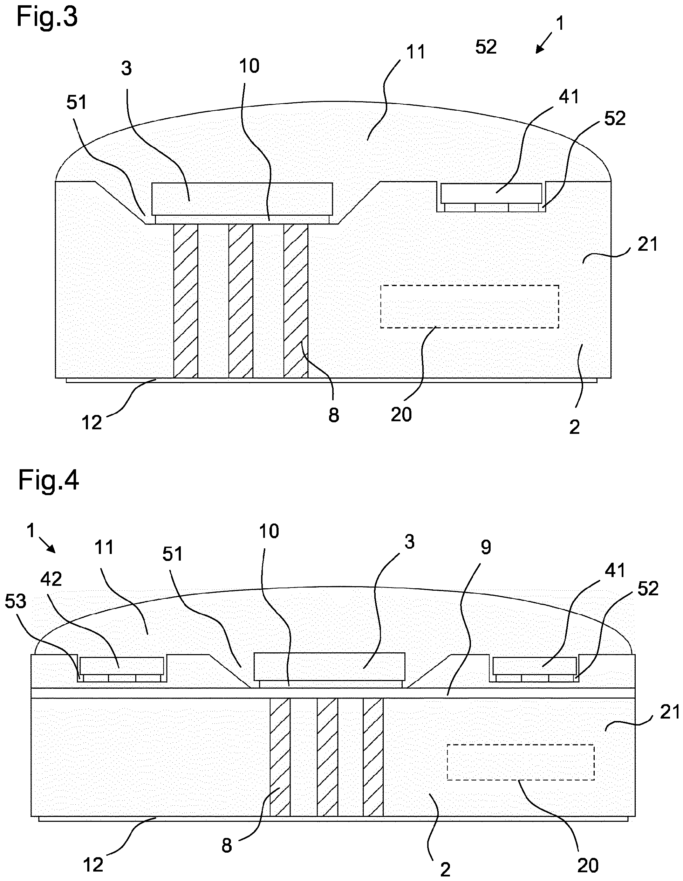

Figur 3 zeigt eine Leuchtdiodenvorrichtung 1 gemäß einem weiteren nicht erfindungsgemäßen Ausführungsbeispiel. Im Unterschied zu dem in Figur 1 gezeigten Ausführungsbeispiel weist die Leuchtdiodenvorrichtung 1 eine weitere Kavität 52 auf, in der ein elektrisches Bauelement 41 vollständig versenkt angeordnet ist. Das elektrische Bauelement 41 ist im gezeigten Ausführungsbeispiel wiederum als NTC-Thermistorbauelement ausgeführt. Alternativ kann das elektrische Bauelement 41 auch als PTC-Thermistorbauelement ausgeführt sein.

Weiterhin weist der Grundkörper 21 Vias 8 auf, die als thermische Vias ausgeführt sind. Die Vias 8 sind von der Kontaktfläche 10 des Leuchtdiodenchips 3 elektrisch leitend isoliert und dienen der Wärmeabfuhr von vom Leuchtdiodenchip 3 im Betrieb erzeugter Wärme. Die Vias 8 weisen im gezeigten Ausführungsbeispiel hierzu Kupfer auf. Alternativ können die Vias 8 auch andere Materialien mit einer hohen Wärmeleitfähigkeit, wie zum Beispiel Silber oder Silber-Palladium, aufweisen. Die Vias 8 verlaufen in etwa senkrecht zu einer Oberfläche des Grundkörpers 21. Weiterhin können ein oder mehrere Vias, vorzugsweise zumindest zwei Vias, als elektrische Vias ausgeführt sein, die elektrisch leitend mit Kontaktflächen 10 des Leuchtdiodenchips 3 verbunden sind und der elektrischen Kontaktierung des Leuchtdiodenchips 3 dienen.

In Figur 4 ist eine Leuchtdiodenvorrichtung 1 gemäß einem erfindungsgemäßen Ausführungsbeispiel gezeigt. Im Unterschied zu dem in Figur 3 gezeigten Ausführungsbeispiel weist der Träger 2 eine zweite weitere Kavität 53 auf, in der ein weiteres elektrisches Bauelement 42 vollständig versenkt angeordnet ist. Die Leuchtdiodenvorrichtung 1 umfasst somit zwei elektrische Bauelemente 41, 42, die in verschiedenen Kavitäten 52, 53 angeordnet sind. Erfindungsgemäß ist eines der zwei elektrischen Bauelemente 41, 42 als NTC-Thermistorbauelement und das andere als PTC-Thermistorbauelement ausgeführt, wobei das NTC-Thermistorbauelement als thermischer Sensor und das PTC-Thermistorbauelement als Überstromschutzelement wirkt. Erfindungsgemäß sind das elektrische Bauelement und das weitere elektrische Bauelement in einer Kavität vollständig versenkt angeordnet. Durch eine derartige Anordnung kann ein besonders kompaktes Design einer Leuchtdiodenvorrichtung 1, welche einen Leuchtdiodenchip 3 und zwei elektrische Bauelemente 41, 42 aufweist, erzielt werden.

Weiterhin weist der Träger 2 der Leuchtdiodenvorrichtung 1 einen Grundkörper 21 aus einem organischen Material auf oder besteht daraus. Alternativ dazu kann der Grundkörper 21 auch Aluminiumoxid oder Aluminiumnitrid aufweisen oder aus Aluminiumoxid oder Aluminiumnitrid bestehen.

Der Träger 2 weist des Weiteren eine Isolationsschicht 9, die als elektrisch isolierende Passivierungsschicht wirkt, auf. Die Isolationsschicht 9 weist Siliziumoxid auf. Alternativ kann die Isolationsschicht auch Siliziumnitrid, Aluminiumoxid Aluminiumnitrid, Titanoxid oder eine LTCC-Keramik aufweisen.

Durch die Isolationsschicht 9 kann die den Leuchtdiodenchip 3 tragende Oberseite des Trägers 2 von der gegenüberliegenden Unterseite elektrisch isoliert werden. Dabei ist die Dicke der Isolationsschicht 9 bevorzugt derart gewählt, dass eine möglichst gute Wärmeleitfähigkeit erhalten bleibt. Mit anderen Worten sollte die Isolationsschicht im Hinblick auf die thermische Leitfähigkeit möglichst dünn sein und im Hinblick auf die elektrische Isolation eine ausreichende Mindestdicke aufweisen.

Figur 5 zeigt eine schematische Darstellung eines ESD-Schutzelements 20 gemäß einem Ausführungsbeispiel. Das ESD-Schutzelement 20 weist ein keramisches Varistormaterial aus ZnO-Pr und mehrere sich überlappende Elektroden 13 auf, die mittels Vias 8 elektrisch kontaktiert werden. Alternativ kann das Varistormaterial ZnO-Bi oder SrTiO3 aufweisen. Des Weiteren ist es möglich, dass das ESD-Schutzelement 20 ein Komposit aus ZnO-Pr und Glas oder ein Komposit aus ZnO-Pr und einem organischen Material aufweist. Das in Figur 5 gezeigte ESD-Schutzelement 20 ist vorzugsweise in einem Träger 2 einer Leuchtdiodenvorrichtung 1, wie sie in den Figuren 1 bis 4 dargestellt ist, integriert. Beispielsweise kann das ESD-Schutzelement 20 im Träger 2 oder im Grundkörper 21 vergraben sein. Dadurch kann ein kompaktes Design einer einen ESD-Schutz aufweisenden Leuchtdiodenvorrichtung 1 erzielt werden.

Die in den gezeigten Ausführungsbeispielen beschriebenen Merkmale können gemäß weiteren Ausführungsbeispielen auch miteinander kombiniert sein, auch wenn solche Kombinationen nicht explizit in den Figuren gezeigt sind. Weiterhin können die gezeigten Leuchtdiodenvorrichtungen weitere oder alternative Merkmale gemäß den oben im allgemeinen Teil beschriebenen Ausführungsformen aufweisen.

### Bezugszeichenliste

- 1: Leuchtdiodenvorrichtung
- 2: Träger
- 20: ESD-Schutzelement
- 21: Grundkörper
- 3: Leuchtdiodenchip
- 41: elektrisches Bauelement
- 42: weiteres elektrisches Bauelement
- 51: Kavität
- 52, 53: weitere Kavität
- 71: Bodenfläche
- 72: Seitenfläche
- 8: Via
- 9: Isolationsschicht
- 10: Kontaktfläche
- 11: Schutzbeschichtung
- 12: Metallisierung
- 13: Elektrode

## Patentansprüche

1. Leuchtdiodenvorrichtung (1), aufweisend
- einen Träger (2), der zumindest eine Kavität (51) oder mehrere Kavitäten (51, 52, 53) aufweist,
- einen Leuchtdiodenchip (3), der zumindest teilweise versenkt in der zumindest einen Kavität (51) angeordnet ist oder der auf dem Träger (2) angeordnet ist,
- ein ESD-Schutzelement (20), das durch einen Teilbereich des Trägers (2) gebildet wird,
**dadurch gekennzeichnet, dass**
die Leuchtdiodenvorrichtung (1) ein elektrisches Bauelement (41) und ein weiteres elektrisches Bauelement (42) auf dem Träger (2) aufweist, die in einer oder in mehreren Kavitäten (52, 53) vollständig versenkt angeordnet sind, wobei eines der elektrischen Bauelemente (41, 42) als NTC-Thermistorbauelement und das andere der elektrischen Bauelemente (41, 42) als PTC-Thermistorbauelement ausgeführt ist und wobei der Leuchtdiodenchip (3) vom elektrischen Bauelement (41) und vom weiteren elektrischen Bauelement (42) optisch getrennt ist.

2. Leuchtdiodenvorrichtung nach Anspruch 1, wobei der Leuchtdiodenchip (3) vollständig versenkt in der zumindest einen Kavität (51) angeordnet ist.

3. Leuchtdiodenvorrichtung nach Anspruch 1 oder 2, wobei das elektrische Bauelement (41) vollständig versenkt in einer weiteren Kavität (51) angeordnet ist.

4. Leuchtdiodenvorrichtung nach einem der vorherigen Ansprüche, wobei das elektrische Bauelement (41) und das weitere elektrische Bauelement (42) in derselben Kavität angeordnet sind.

5. Leuchtdiodenvorrichtung nach einem der vorherigen Ansprüche, wobei das elektrische Bauelement (41) und das weitere elektrische Bauelement (42) in zwei separaten Kavitäten angeordnet sind, von denen die eine auf derselben Seite des Trägers (2) wie der Leuchtdiodenchip (3) und die andere auf der dem Leuchtdiodenchip (3) gegenüberliegenden Seite des Trägers (2) angeordnet ist.

6. Leuchtdiodenvorrichtung nach einem der vorherigen Ansprüche, wobei das PTC-Thermistorbauelement als Schutzbauelement gegen Überströme und das NTC-Thermistorbauelement als Temperatursensor in die Leuchtdiodenvorrichtung integriert sind.

7. Leuchtdiodenvorrichtung nach einem der vorhergehenden Ansprüche, wobei das ESD-Schutzelement (20) ein Komposit aus einem Varistormaterial und einem Metall aufweist.

8. Leuchtdiodenvorrichtung nach einem der vorherigen Ansprüche, wobei das ESD-Schutzelement (20) durch eine in den Träger integrierte Halbleiterdiode gebildet ist.

9. Leuchtdiodenvorrichtung nach einem der vorhergehenden Ansprüche, wobei der Träger (2) einen keramischen Grundkörper (21) oder einen Grundkörper (21), der ein organisches Material aufweist, oder einen Grundkörper, der ein halbleitendes Material aufweist, aufweist.

10. Leuchtdiodenvorrichtung nach Anspruch 9, wobei der Grundkörper (21) SrTiO₃, ZnO-Pr oder ZnO-Bi aufweist.

11. Leuchtdiodenvorrichtung nach Anspruch 9 oder 10, wobei der Grundkörper (21) ein Komposit aus ZnO-Pr und Glas oder ein Komposit aus ZnO-Pr und einem organischen Material aufweist.

12. Leuchtdiodenvorrichtung nach Anspruch 9, wobei der Grundkörper (21) Aluminiumoxid oder Aluminiumnitrid aufweist.

13. Leuchtdiodenvorrichtung nach einem der Ansprüche 9 bis 12, wobei der Grundkörper (21) eine Isolationsschicht (9) aufweist, die Titanoxid, Aluminiumoxid, Aluminiumnitrid, Siliziumoxid oder Siliziumnitrid aufweist und die eine den Leuchtdiodenchip (3) tragende Oberseite des Trägers (2) von einer gegenüberliegenden Unterseite des Trägers (2) elektrisch isoliert.

14. Leuchtdiodenvorrichtung nach einem der Ansprüche 9 bis 13, wobei der Grundkörper (21) Vias (8) aufweist und wobei zumindest ein Via (8) als thermisches Via ausgeführt ist.

## Claims

1. Light-emitting diode device (1), comprising
- a carrier (2) having at least one cavity (51) or a plurality of cavities (51, 52, 53),
- a light-emitting diode chip (3), which is arranged in a manner at least partly recessed in the at least one cavity (51) or which is arranged on the carrier (2),
- an ESD protection element (20), which is formed by a partial region of the carrier (2),
**characterized in that** the light-emitting diode device (1) comprises an electrical component (41) and a further electrical component (42) on the carrier (2), which components are arranged in a manner completely recessed in one or in a plurality of cavities (52, 53), wherein one of the electrical components (41, 42) is embodied as an NTC thermistor component and the other one of the electrical components (41, 42) is embodied as a PTC thermistor component and wherein the light-emitting diode chip (3) is optically separated from the electrical component (41) and from the further electrical component (42).

2. Light-emitting diode device according to Claim 1, wherein the light-emitting diode chip (3) is arranged in a manner completely recessed in the at least one cavity (51).

3. Light-emitting diode device according to Claim 1 or 2, wherein the electrical component (41) is arranged in a manner completely recessed in a further cavity (51) .

4. Light-emitting diode device according to any of the preceding claims, wherein the electrical component (41) and the further electrical component (42) are arranged in the same cavity.

5. Light-emitting diode device according to any of the preceding claims, wherein the electrical component (41) and the further electrical component (42) are arranged in two separate cavities, of which one is arranged on the same side of the carrier (2) as the light-emitting diode chip (3) and the other is arranged on the opposite side of the carrier (2) relative to the light-emitting diode chip (3).

6. Light-emitting diode device according to any of the preceding claims, wherein the PTC thermistor component as a protection component against overcurrents and the NTC thermistor component as a temperature sensor are integrated into the light-emitting diode device.

7. Light-emitting diode device according to any of the preceding claims, wherein the ESD protection element (20) comprises a composite composed of a varistor material and a metal.

8. Light-emitting diode device according to any of the preceding claims, wherein the ESD protection element (20) is formed by a semiconductor diode integrated into the carrier.

9. Light-emitting diode device according to any of the preceding claims, wherein the carrier (2) comprises a ceramic main body (21) or a main body (21) comprising an organic material, or a main body comprising a semiconducting material.

10. Light-emitting diode device according to Claim 9, wherein the main body (21) comprises SrTiO₃, ZnO-Pr or ZnO-Bi.

11. Light-emitting diode device according to Claim 9 or 10, wherein the main body (21) comprises a composite composed of ZnO-Pr and glass or a composite composed of ZnO-Pr and an organic material.

12. Light-emitting diode device according to Claim 9, wherein the main body (21) comprises aluminum oxide or aluminum nitride.

13. Light-emitting diode device according to any of Claims 9 to 12, wherein the main body (21) comprises an insulation layer (9) which comprises titanium oxide, aluminum oxide, aluminum nitride, silicon oxide or silicon nitride and which electrically insulates a top side of the carrier (2), said top side carrying the light-emitting diode chip (3), from an opposite underside of the carrier (2).

14. Light-emitting diode device according to any of Claims 9 to 13, wherein the main body (21) has vias (8), and wherein at least one via (8) is embodied as a thermal via.

## Revendications

1. Dispositif à diode électroluminescente (1), comprenant
- un support (2) qui comporte au moins une cavité (51) ou plusieurs cavités (51, 52, 53),
- une puce de diode électroluminescente (3) qui est au moins partiellement encastrée dans au moins une cavité (51) ou qui est disposée sur le support (2),
- un élément de protection ESD (20) formé par une zone partielle du support (2),
**caractérisé en ce que** le dispositif à diode électroluminescente (1) comprend un composant électrique (41) et un autre composant électrique (42) sur le support (2), qui sont disposés de manière entièrement encastrée dans une ou plusieurs cavités (52, 53), dans lequel l'un des composants électriques (41, 42) est réalisé sous la forme d'un composant de thermistance NTC et l'autre des composants électriques (41, 42) est réalisé sous la forme d'un composant de thermistance PTC et dans lequel la puce de diode électroluminescente (3) est optiquement séparée du composant électrique (41) et de l'autre composant électrique (42).

2. Dispositif à diode électroluminescente selon la revendication 1, dans lequel la puce de diode électroluminescente (3) est complètement encastrée dans ladite au moins une cavité (51).

3. Dispositif à diode électroluminescente selon la revendication 1 ou 2, dans lequel le composant électrique (41) est entièrement encastré dans une autre cavité (51).

4. Dispositif à diode électroluminescente selon l'une quelconque des revendications précédentes, dans lequel le composant électrique (41) et l'autre composant électrique (42) sont disposés dans la même cavité.

5. Dispositif à diode électroluminescente selon l'une quelconque des revendications précédentes, dans lequel le composant électrique (41) et l'autre composant électrique (42) sont disposés dans deux cavités séparées, dont l'une est disposée sur le même côté du support (2) que la puce de diode électroluminescente (3) et dont l'autre est disposée sur le côté du support (2) qui est opposé à la puce de diode électroluminescente (3).

6. Dispositif à diode électroluminescente selon l'une quelconque des revendications précédentes, dans lequel le composant de thermistance PTC est intégré en tant que dispositif de protection contre les surintensités et le composant de thermistance NTC est intégré dans le dispositif à diode électroluminescente en tant que capteur de température.

7. Dispositif à diode électroluminescente selon l'une quelconque des revendications précédentes, dans lequel l'élément de protection ESD (20) comprend un composite d'un matériau de varistance et d'un métal.

8. Dispositif à diode électroluminescente selon l'une quelconque des revendications précédentes, dans lequel l'élément de protection ESD (20) est formé par une diode semi-conductrice intégrée dans le support.

9. Dispositif à diode électroluminescente selon l'une quelconque des revendications précédentes, dans lequel ledit support (2) comprend un corps de base céramique (21) ou un corps de base (21) comportant une matière organique, ou un corps de base comportant une matière semi-conductrice.

10. Dispositif à diode électroluminescente selon la revendication 9, dans lequel le corps de base (21) comprend du SrTiO₃, du ZnO-Pr ou du ZnO-Bi.

11. Dispositif à diode électroluminescente selon la revendication 9 ou 10, dans lequel le corps de base (21) comprend un composite de ZnO-Pr et de verre ou un composite de ZnO-Pr et d'une matière organique.

12. Dispositif à diode électroluminescente selon la revendication 9, dans lequel le corps de base (21) comprend de l'oxyde d'aluminium ou du nitrure d'aluminium.

13. Dispositif à diode électroluminescente selon l'une quelconque des revendications 9 à 12, dans lequel le corps de base (21) comporte une couche isolante (9) qui comprend de l'oxyde de titane, de l'alumine, du nitrure d'aluminium, de l'oxyde de silicium ou du nitrure de silicium et qui isole électriquement une face supérieure du support (2) supportant la puce de diode électroluminescente (3) d'une face inférieure opposée du support (2).

14. Dispositif à diode électroluminescente selon l'une quelconque des revendications 9 à 13, dans lequel le corps de base (21) comprend des trous traversants (8) et dans lequel au moins un trou traversant (8) est réalisé sous la forme d'un trou traversant thermique.
